# EUROPEAN PATENT APPLICATION

(11) **EP 1 857 829 A2**
(43) Date of publication of application: **21.11.2007**
(21) Application number: 07006261.7
(22) Date of filing: 27.03.2007
(51) Int. Cl.: G01R 33/00

(54) **Magnetic sensor with limited element width**

(30) Priority: 30.03.2006 JP 2006094230
(71) Applicant: ALPS ELECTRIC CO., LTD., Tokyo 145-8501 (JP)
(72) Inventor: Sasaki, Yoshito, Ota-ku Tokyo 145-8501 (JP)
(74) Representative: Klunker . Schmitt-Nilson . Hirsch

(57) **Abstract**

Particularly, there is provided a magnetic sensor capable of preventing an occurrence of a chattering or the like to provide a stable operation and easily controlling a magnetic sensitivity depending on applications. The magneto-resistance element 8 is formed in a slender and longitudinal shape in which an element length L is greater than an element width W and the element width W is in the range of 1 µm to 5 µm. The element length L is in the range of 50 µm to 250 µm. Owing to the result, it is possible to easily control a coercive force Hc of the free layer with required magnitude. In addition, the coercive force Hc may be in the range of 5 Oe to 10 Oe (about 395 A/m to 790 A/m) by setting the element width W in the range of 1 µm to 5 µm.

## Description

### BACKGROUND OF THE INVENTION

### 1. Field of the Invention

The invention relates to a non-contact magnetic sensor including a magneto-resistance element, and more particularly, to a magnetic sensor preventing a chattering or the like so as to provide a stable operation. The magneto-resistance element has a flexibility in magnetic sensitivity for adapting itself to a variety of applications. 2.Description of the related art

A non-contact switch such as a magnetic switch using a Hall element is known (for example, see Patent Document 1: Japanese Unexamined Patent Application Publication No. 8-17311). A magnetic switch using a magneto-resistance element is also known (for example, see Patent Document 2: Japanese Unexamined Patent Application Publication No. 2003-66127).

However, the magnetic switch using the Hall element disclosed in Patent Document 1 could not have provided a stable operation, since such an erroneous operation occurs when external noises and the like get mixed in the switch.

Additionally, it is well known that an output voltage V of the Hall element is determined by the formula of V = R_{H}·I·B/d when a Hall coefficient is R_{H}, a thickness of the Hall element is d, a current is I, and the external magnetic field density is B, whereby the Hall coefficient R_{H} and the thickness d is a fixed factor predetermined by a choice of the Hall element. Because of the reason, to obtain a large output voltage V in an object of a stable switch operation, it has been required to set large values of the current I and/or the magnetic flux density B. However, if the method setting the larger current I is applied, a power consumption of the magnetic switch increases. Additionally, if the method setting the larger magnetic flux density B is applied, it is required to be large a magnet forming the external magnetic field or employ a rare-earth magnet such as a neodymium magnet. Therefore, there had been problems that the magnetic switch increases in size in the former method and a cost rises in the later method.

In addition, according to the patent document 2, there is described about a magnetic sensor having a magneto-resistance element, but there is neither any description nor any implication about flexibility of a magnetic sensitivity and the like.

### SUMMARY OF THE INVENTION

The present application is contrived to solve the aforementioned problems in the past, and particularly, it is an object of the application to provide a magnetic sensor capable of preventing an occurrence of a chattering or the like to obtain a stable operation and easily controlling a magnetic sensitivity depending on applications.

According to an aspect of the application, there is provided a magnetic sensor including a magneto-resistance element, wherein the magneto-resistance element includes an anti-ferromagnetic layer, a fixed layer which is formed in contact with the anti-ferromagnetic layer and of which a magnetization direction is fixed, and a free layer which is opposed to the fixed layer with a non-magnetic layer interposed therebetween and of which a magnetization direction varies in accordance with an external magnetic field. Here, the magneto-resistance element is formed in a slender and longitudinal shape in which an element length L is greater than an element width W and the element width W is in the range of 1 µm to 5 µm.

According to an experiment mentioned later, it is realized that while an alteration in the element length L causes only a slight alteration in the coercive force Hc, an alteration in the element width W causes an effective alteration in the coercive force Hc. As mentioned above, the element width W in the range of 1 µm to 5 µm gives flexibility to the element in a coercive force Hc of the free layer forming the magneto-resistance element. The reason that a minimum value of the element width W is set to be 1 µm is, if the element width W is formed to be smaller than 1 µm*,* a variation in the coercive force Hc is greatly increased by a variation in the element width W and the irregularity of the coercive force Hc is easy to increase. Larger element widths, larger than 5pm, cause a decrease in the coercive force and lead to a malfunction such as an unexpected chattering and, in addition, cause a decrease in the resistance of the magneto-resistance element. Because of the aforementioned reason, it may be required that the element length L is set to be long to increase the resistance to predetermined value. From the result, a decrease in size of the magnetic sensor may not be promoted. Therefore, according to the application, the element width W is set in the range of 1 µm to 5 µm. Additionally, the coercive force Hc may be in the range of 5 Oe to 10 Oe (about 395 A/m to 790 A/m) by setting the element width W in the range of 1 µm to 5 µm.

In the above-mentioned configuration, the element length L may be in the range of 50 µm to 250 µm. Further, according to the application, the non-magnetic layer may be formed of Cu, and a thickness of the non-magnetic layer may be formed in the range of 17 Å to 19 Å. A magnitude of an interlayer coupling magnetic field Hin acting between the fixed layer and the free layer may change by changing the thickness of the non-magnetic layer. The interlayer coupling magnetic field Hin may be set at least 5 Oe or more, preferably 10 Oe or more, when the thickness of the non-magnetic layer 18 is in the range of 17 Å to 19 Å. Specifically, the interlayer coupling magnetic field Hin may be set to be larger than the coercive force Hc. For example, if a hysteresis loop may be illustrated on a graph of which a horizontal axis represents the external magnetic field H and a vertical axis represents the resistance variation rate (ΔR/R) of the magneto-resistance element so that the interlayer coupling magnetic field Hin is larger than the coercive force Hc, then the hysteresis loop is not laid across the vertical axis of the external magnetic field H equal to 0 (Oe) and shifts to left or right of the vertical axis of the external magnetic field H equal to 0. The magnetic sensor provided with the magneto-resistance element having the hysteresis characteristic as just described may have a control unit outputting a switching signal on the basis of an output variation due to a variation in a magnitude of the external magnetic field. Therefore, an ON and OFF switching signal may be outputted on the basis of the variation of the magnitude of the external magnetic field. For example, if the magnetic sensor according to the application comes close to the magnet, then gives an ON signal (or OFF signal) output, and if the magnet withdraws from the magnetic sensor, then gives an OFF signal (or ON signal) output. For example, the magnetic sensor according to the application may be effectively used in an opening and closing detection of the foldable cellular phone.

Alternately, in the above-mentioned configuration, the non-magnetic layer may be formed of Cu, and a thickness of the non-magnetic layer may be formed in the range of 19.5 Å to 21 Å. From the result, the interlayer coupling magnetic field Hin may be set to be 5 Oe or less. Specifically, the interlayer coupling magnetic field Hin can be set to be smaller than the coercive force Hc of the free layer. For example, if a hysteresis loop may be illustrated on a graph of which a horizontal axis represents the external magnetic field H and a vertical axis represents the resistance variation rate (ΔR/R) of the magneto-resistance element so that the interlayer coupling magnetic field Hin is smaller than the coercive force Hc, then the hysteresis loop is laid across the vertical axis of the external magnetic field H equal to 0 (Oe). The magnetic sensor provided with the magneto-resistance element having the hysteresis characteristic as just described may have a control unit outputting a switching signal on the basis of an output variation due to a polarity change in a magnitude of the external magnetic field. Therefore, an ON and OFF switching signal may be outputted on the basis of the polarity change of the magnitude of the external magnetic field. For example, if the magnetic sensor according to the application is close to an N pole, then an ON signal (or OFF signal) is outputted, and if the magnetic sensor is close to a S pole, then an OFF signal (or ON signal) is outputted.

In the above-mentioned configuration, a magnetic sensor including a magneto-resistance element, wherein the magneto-resistance element includes an anti-ferromagnetic layer, a fixed layer which is formed in contact with the anti-ferromagnetic layer and of which a magnetization direction is fixed, and a free layer which is opposed to the fixed layer with a non-magnetic layer interposed therebetween and of which a magnetization direction varies with an external magnetic field, and wherein an interlayer coupling magnetic field Hin acting between the fixed layer and the free layer of the magneto-resistance element is greater than a coercive force Hc of the free layer.

As mentioned above, for example, when a hysteresis loop may be illustrated on a graph of which a horizontal axis represents the external magnetic field H and a vertical axis represents the resistance variation rate (ΔR/R) of the magneto-resistance element so that the interlayer coupling magnetic field Hin is larger than the coercive force Hc, then the hysteresis loop is not laid across the vertical axis of the external magnetic field H equal to 0 (Oe) and shifts to left or right of the vertical axis of the external magnetic field H equal to 0. The magnetic sensor provided with the magneto-resistance element having the hysteresis characteristic as just described may have a control unit outputting a switching signal on the basis of an output variation due to a variation in a magnitude of the external magnetic field. Therefore, an ON and OFF switching signal may be outputted on the basis of the variation of the magnitude of the external magnetic field. For example, if the magnetic sensor according to the application is close to the magnet, then an ON signal (or OFF signal) is outputted, and if the magnet withdraws from the magnetic sensor, then an OFF signal (or ON signal) is outputted. For example, the magnetic sensor according to the application may be effectively used in an opening and closing detection of the foldable cellular phone.

In the above-mentioned configuration, a magnetic sensor may prevent an occurrence of a chattering or the like to obtain a stable operation. Additionally, a magnetic sensor may easily control a magnetic sensitivity depending on applications.

### BRIEF DESCRIPTION OF THE DRAWING

Fig. 1 is a schematic partial diagram of a foldable cellular phone including a magnetic sensor of the embodiment (i.e. folding state).
Fig.2 is a schematic partial diagram of a foldable cellular phone including a magnetic sensor of the embodiment (i.e. opening state).
Fig. 3 is a partial top view of a magnetic sensor according to the embodiment.
Fig 4 is a partial sectional view of the magnetic sensor taken along line A-A of Fig. 3 as viewed in the direction of an arrow.
Fig. 5 is a partial sectional view of a non-contact magnetic sensor different from that of Fig. 4.
Fig. 6 is a partial sectional view of a non-contact magnetic sensor different from those of Figs. 4 and 5.
Fig. 7 is a graph illustrating a hysteresis characteristic of a fixed resistance element built in the magnetic sensor in Fig. 6.
Fig. 8 is a diagram illustrating a circuit configuration of the magnetic sensor illustrated in Fig. 3.
Fig. 9 is a perspective view of a switching mechanism having a magnetic sensor of a second embodiment.
Fig. 10 is a diagram illustrating an operation of a switch illustrated in Fig. 8.
Fig. 11 is a diagram illustrating an operation of a switch illustrated in Fig. 8.
Fig. 12 is a graph illustrating a relation between an element width of a magneto-resistance element and a coercive force Hc of a free layer according to the embodiment.
Fig. 13 is a graph illustrating a relation between a thickness of a non-magnetic layer and an interlayer coupling magnetic field acting between a free layer and a fixed of a magneto-resistance element layer according to the embodiment.
Fig. 14 is a graph illustrating a hysteresis characteristic of a magneto-resistance element according to a first embodiment.
Fig. 15 is a graph illustrating a hysteresis characteristic of a magneto-resistance element according to the second embodiment.

### DESCRIPTION OF THE PREFERRED EMBODIMENTS

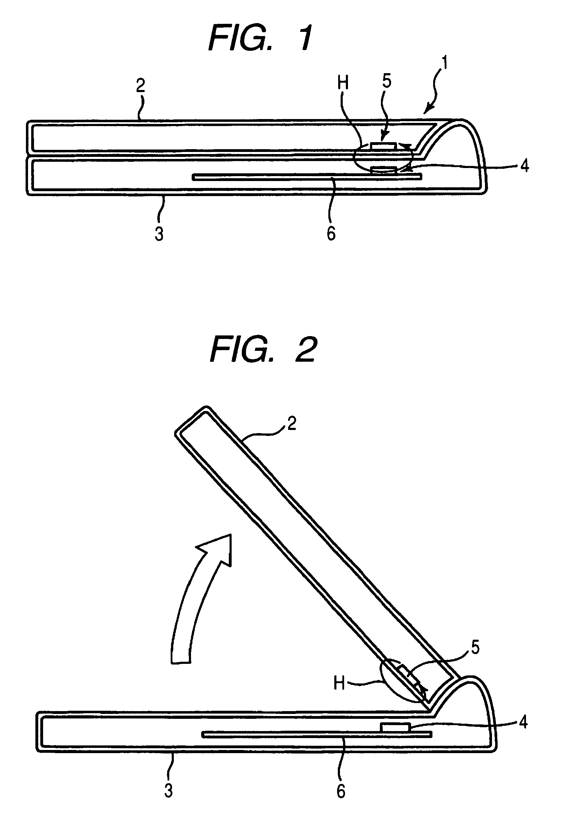

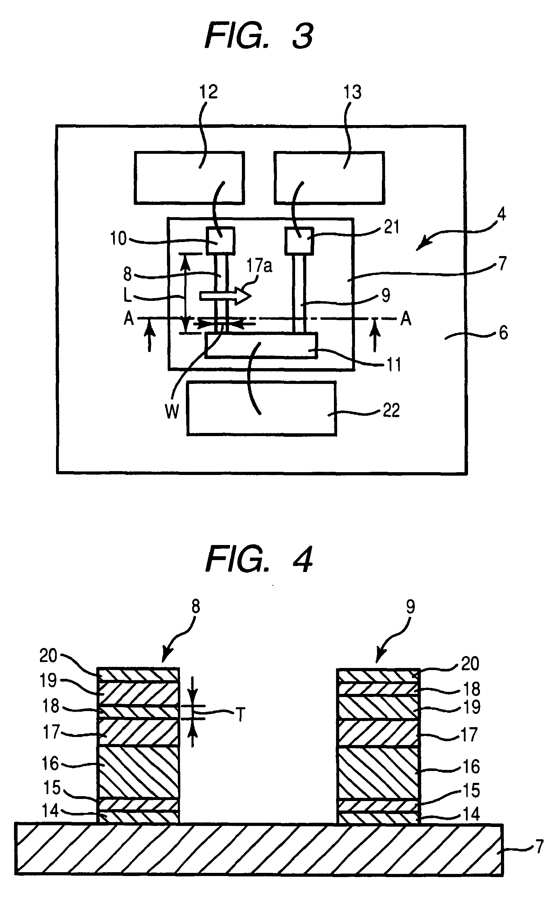

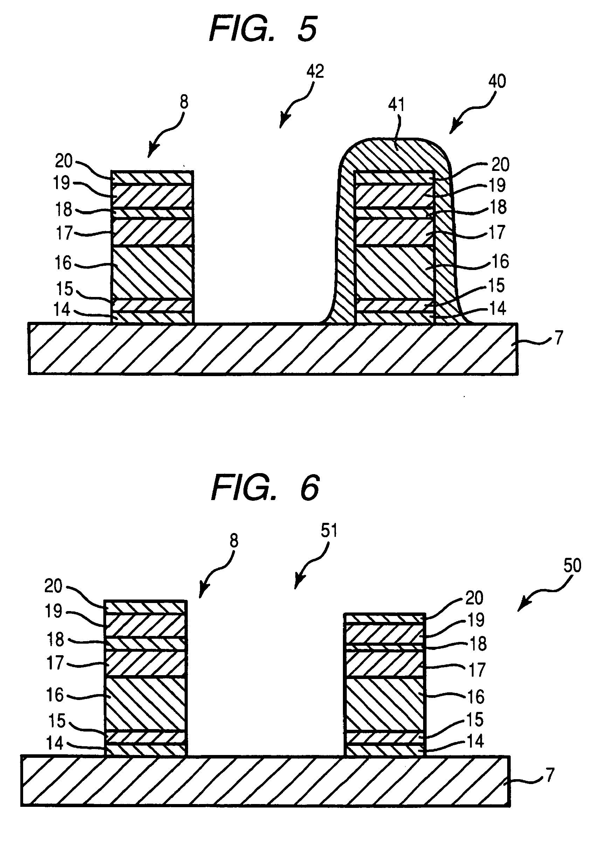

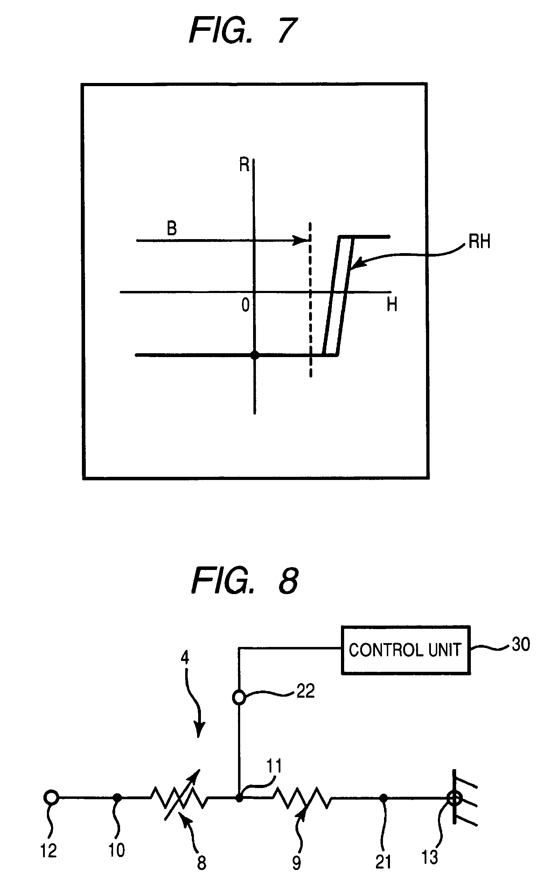

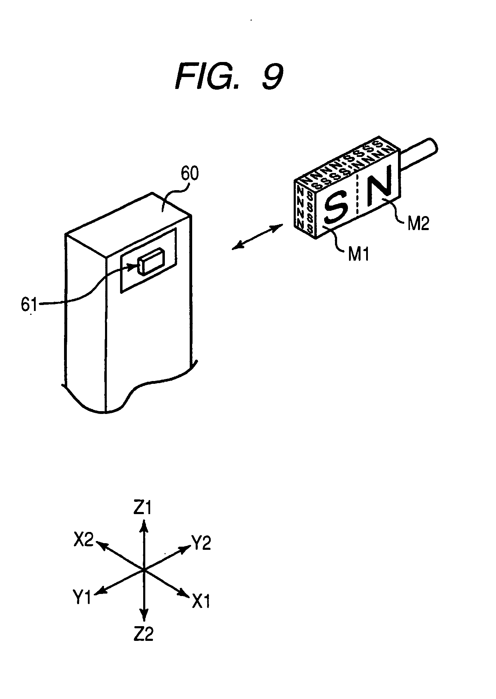

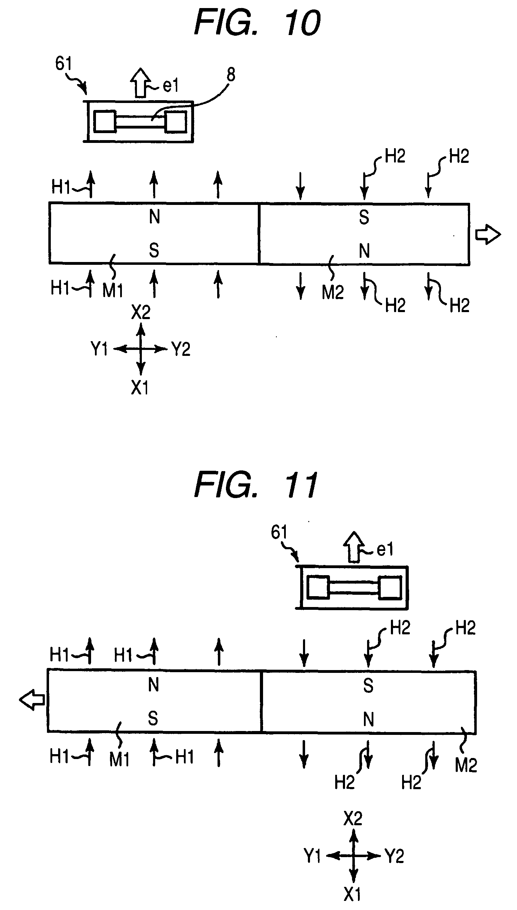

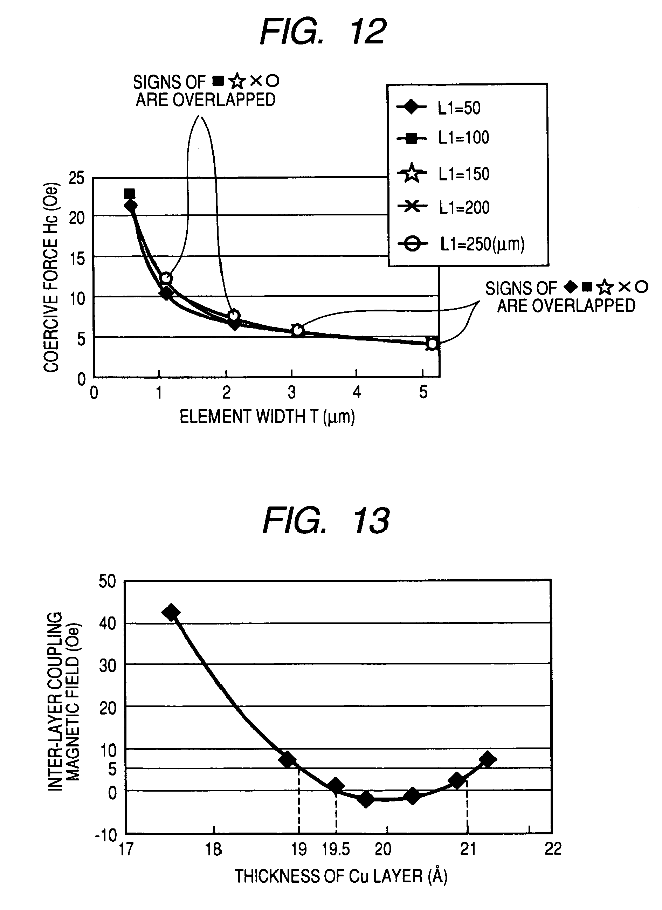

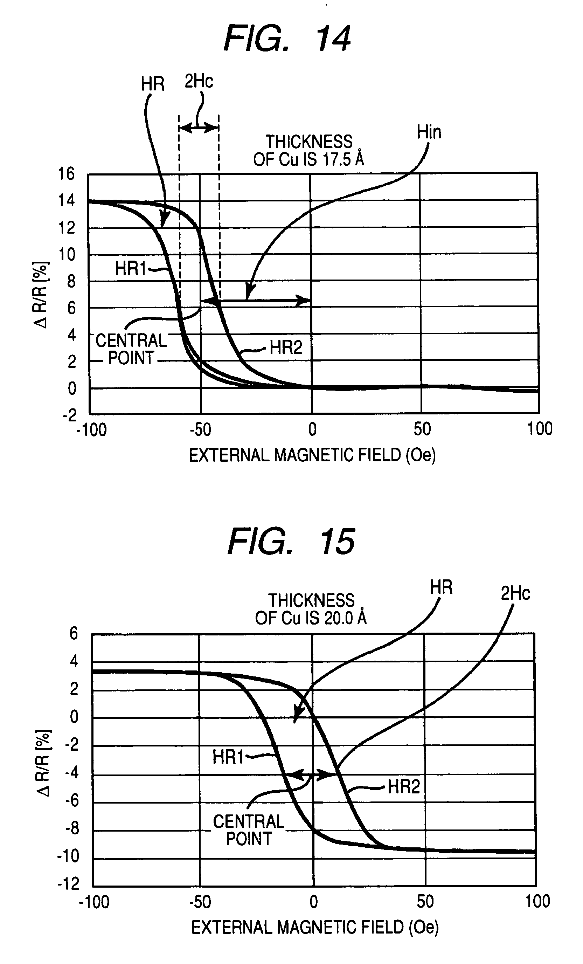

Figs. 1 and 2 are schematic partial diagrams illustrating a foldable cellular phone including a magnetic sensor of the first embodiment. Fig. 3 is a partial top view of a magnetic sensor according to the embodiment. Fig 4 is a partial sectional view of the magnetic sensor taken along line A-A of Fig. 3 as viewed in the direction of an arrow. Fig. 5 is a partial sectional view of a non-contact magnetic sensor different from that of Fig. 4. Fig. 6 is a partial sectional view of a non-contact magnetic sensor different from those of Figs. 4 and 5. Fig. 7 is a graph illustrating a hysteresis characteristic of a fixed resistance element built in the magnetic sensor in Fig. 6. Fig. 8 is a diagram illustrating a circuit configuration of the magnetic sensor illustrated in Fig. 3. Fig. 9 is a perspective view of a switching mechanism having a magnetic sensor of a second embodiment. Figs. 10 and 11 are a diagram illustrating an operation of a switch illustrated in Fig. 8. Fig. 12 is a graph illustrating a relation between an element width of a magneto-resistance element and a coercive force Hc of a free layer according to the embodiment. Fig. 13 is a graph illustrating a relation between a thickness of a non-magnetic layer and an interlayer coupling magnetic field acting between a free layer and a fixed of a magneto-resistance element layer according to the embodiment. Fig. 14 is a graph illustrating a hysteresis characteristic of a magneto-resistance element according to a first embodiment. Fig. 15 is a graph illustrating a hysteresis characteristic of a magneto-resistance element according to the second embodiment.

As shown in Fig. 1, a foldable cellular phone 1 includes a first member 2 and a second member 3. The first member 2 is a screen display part, and the second member 3 is a manipulation part. A facing surface of the first member 2 with the second member 3 is provided with a liquid crystal display, a receiver or the like. A facing surface of the second member 3 with the first member 2 is provided with various type buttons and a microphone. Fig. 1 is illustrated in folding state of the foldable cellular phone 1. As shown in Fig. 1, the first member 2 has a magnet 5, and the second member 3 has the magnetic sensor 4. Additionally, the magnet 5 and the magnetic sensor 4 are disposed at positions opposed to each other (i.e. opposed to each surface disposed the magnet 5 and the magnetic sensor 4 in a perpendicular direction.) in the folding state as shown in Fig. 1.

In Fig. 1, the external magnetic field H emitted from the magnet 5 acts on the magnetic sensor 4, and the external magnetic field H is detected in the magnetic sensor 4, whereby the folding state of the foldable cellular phone 1 is detected.

Conversely, when the foldable cellular phone 1 is opened as shown in Fig. 2, the first member 2 gradually withdraws from the second member 3, accordingly the magnitude of the external magnetic field H that acts on the magnetic sensor 4 gradually becomes smaller, and then the magnitude of the external magnetic field H acting on the magnetic sensor 4 becomes zero. The magnitude of the external magnetic field H acting on the magnetic sensor 4 is not more than a predetermined value, whereby the foldable cellular phone 1 is detected in an open state. For example, a backlight in a rear side of the liquid crystal display or the manipulation buttons is controlled to emit light by a control unit built in the foldable cellular phone 1.

As shown in fig. 3, the magnetic sensor 4 of the embodiment is mounted on a circuit board 6 built in the second member 3. The magnetic sensor 4 is provided with a magneto-resistance element 8 and a fixed resistance element 9 on a base element 7. As shown in Fig. 3, both end of the magneto-resistance element 8 in a longitudinal direction are provided with terminal portions 10 and 11. For example, the terminal portion 10 is electrically connected to an input terminal 12 (power source Vcc) provided on the circuit board 6 by using a wire bonding a die bonding or the like (see Fig. 8). The terminal portion 11 is a common terminal for the magneto-resistance element 8 and the fixed resistance element 9. The terminal portion 11 is electrically connected to an output terminal 22 provided on the circuit board 6 by using a wire bonding a die bonding or the like (see Fig. 8).

As shown in Fig. 3, both end of the fixed resistance element 9 in a longitudinal direction are provided with terminal portions 11 and 21. The terminal portion 21 is electrically connected to an earth terminal 13 on the circuit board 6 by using a wire bonding a die bonding or the like (see Fig. 8).

As shown in Fig. 4, the magneto-resistance element 8 has layers which are sequentially laminated from the bottom of an underlying layer 14, a seed layer 15, an anti-ferromagnetic layer 16, a fixed layer 17, a non-magnetic layer 18, a free layer 19, and a passivation layer 20. The underlying layer 14 is formed of a non-magnetic material including at least one element such as Ta, Hf, Nb, Zr, Ti, Mo, W. The seed layer 15 is formed of NiFeCr, Cr or the like. The anti-ferromagnetic layer 16 is formed of an anti-ferromagnetic material containing an element α (but, the α is at least one element of Pt, Pd, Ir, Rh, Ru, Os) and Mn, or an anti-ferromagnetic material containing the element α and an element α' (but, the element α' is at least one element of Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb, and rare-earth elements) and Mn. For example, the anti-ferromagnetic layer 16 is formed of IrMn or PtMn. The fixed layer 17 and the free layer 19 are formed of a magnetic material such as a CoFe alloy, a NiFe alloy, a CoFeNi alloy and the like. The non-magnetic layer 18 is formed of Cu and the like. The passivation layer 20 is formed of Ta and the like. The fixed layer 17 or the free layer 19 have a laminated ferri structure (A laminated structure has a sequential laminated order of the magnetic layer, the non-magnetic layer, and the magnetic layer. The non-magnetic layer is interposed between two of the magnetic layers which has an anti-parallel magnetization direction). Additionally, the fixed layer 17 or the free layer 19 may have the lamination structure of which a plurality of magnetic layers made of a different material is laminated.

In the magneto-resistance element 8, the anti-ferromagnetic layer 16 is formed in contact with the fixed layer 17, whereby an exchange coupling magnetic field (Hex) is imparted on an interface between the anti-ferromagnetic layer 16 and the fixed layer 17 by a heat treatment in a magnetic field. The exchange coupling magnetic field fixes the magnetization direction of the fixed layer 17 in one direction. The magnetization direction 17a of the fixed magnetic layer 17 is indicated as an arrow direction in Fig. 3. The magnetization direction 17a is perpendicular to a longitudinal direction (a direction of the element width). Meanwhile, the free layer 19 is opposed to the fixed layer 17 with the non-magnetic layer 18 interposed therebetween, and a magnetization direction of the free layer 19 is not fixed in one direction. Specifically, the magnetization of the free layer 19 is made to be variable in response of a effect of the external magnetic field.

As shown in Fig. 4, the fixed resistance element 9 has layers which are sequentially laminated from the bottom of an underlying layer 14, a seed layer 15, an anti-ferromagnetic layer 16, a first magnetic layer 17, a second magnetic layer 19, a non-magnetic layer 18, and a passivation layer 20. Moreover, the first magnetic layer 17 in the fixed resistance element 9 is correspond to the fixed layer 17 in the magneto-resistance element 8, and the second magnetic layer 19 in the fixed resistance element 9 is correspond to the free layer 19 in the magneto-resistance element 8. That is, a lamination sequence of the fixed resistance element 9 is configured to change the free layer 19 to the non-magnetic layer 18 of the magneto-resistance element 8 in sequence. A material of common layers in the magneto-resistance element 8 and the fixed resistance element 9 is the same.

According to the embodiment illustrated in Fig. 4, in the fixed resistance element 9, the first magnetic layer 17 is formed in contact with the second magnetic layer 19, and the anti-ferromagnetic layer 16 is formed in contact with any one side of the first magnetic layer 17 and the second magnetic layer 19. In Fig. 4, since a laminated structure has a sequential lamination order of the anti-ferromagnetic layer 16, the first magnetic layer 17, and the second magnetic layer 19, an exchange coupling magnetic field (Hex) is imparted on an interface between the anti-ferromagnetic layer 16 and the first magnetic layer 17 by a heat process under a magnetic field. The exchange coupling magnetic field fixes the magnetization of the first magnetic layer 17 to one direction. At this time, the magnetization of the second magnetic layer 19 formed in contact with the first magnetic layer 17 is also made to be fixed in the same direction as the magnetization direction of the first magnetic layer 17 by a ferromagnetic coupling acting between the first magnetic layer 17 and the second magnetic layer 19.

Likewise, according to the embodiment in Fig. 4, since just the laminated order is changed by configuring the same layer structure of the magneto-resistance element 8 and the fixed resistance element 9, an irregularity of a temperature coefficient (TCR) of the magneto-resistance element 8 and the fixed resistance element 9 can be suppressed, accordingly the irregularity of the central potential according to a temperature variation can be suppressed. Therefore, the magnetic sensor 4 can be improved in an operational stability.

According to the embodiment of the magnetic sensor, as shown in Figs. 3 and 8, if a input 5 V is applied from the input terminal (a power source Vcc), an output value from the magnetic sensor 4 (a central potential) becomes about 2.5 V in a non-magnetic field state. By a variation in a magnitude of the external magnetic field H from the magnet 5 acting on the magneto-resistance element 8, the magnetization relation (a magnetization state) of the free layer 19 and the fixed layer 17 varies, and then a resistance of the magneto-resistance element 8 varies (it is called a magneto-resistance effect), thereby varying the output value from the magnetic sensor 4.

As shown in Fig. 3, the magneto-resistance element 8 is formed in a slender and long line shape. An element length of the magneto-resistance element 8 is L, and a element width of the magneto-resistance element 8 is T. The element length L is formed to be sufficiently longer than the element width W as shown in Fig. 3. Additionally, though the magneto-resistance element 8 is not formed in a line shape, it may be allowed to be formed in a curve shape such as a meander shape. The element length L in that case is set by a central line length of the element width W.

According to the embodiment, the element width W is in the range of 1 µm to 5 µm. It is also preferable that the element length L be in the range of 50 µm to 250 µm. Owing to the result, it is possible to easily control a coercive force Hc of the free layer 19 forming the magneto-resistance element 8. Fig. 12 is a graph illustrating a relation between an element width W obtained by an experiment being mentioned later and a coercive force Hc of a free layer 19 according to the embodiment. As shown in Fig. 12, the coercive force Hc almost not depends on the element length L, and depends on the element width W. If the element width W is formed to be smaller than 1 µm as shown in Fig. 12, the coercive force Hc is greatly increased and a variation in the coercive force Hc is greatly increased by a variation in the element width W. Therefore the irregularity of the coercive force Hc is easy to increase. If the element width W is formed to be larger than 5 µm, the coercive force Hc is too decrease to be a magnetic sensor 4 easily occurring an erroneous operation such as a chattering by getting mixed with external noises. In addition, if the element width W is formed to be larger than 5 µm, the resistance of the magneto-resistance element 8 is decrease. Because of the aforementioned reason, it is required that the element length L is set to be long to increase the resistance to predetermined value. From the result, the magnetic sensor 4 increases in size. Alternately, if the element width W is in the range of 1 µm to 5 µm, it is possible to secure the larger coercive force Hc. It is also possible to perform easily a control of the coercive force Hc since the variation in coercive force Hc is not so big according to the variation in the element width W. According to embodiment, the coercive force Hc of the free layer 19 may be in the range of 5 Oe to 10 Oe (about 395 A/m to 790 A/m) by setting the element width W in the range of 1 µm to 5 µm. A control of a magnetic sensitivity can be properly performed by performing a control of the coercive force Hc caused by controlling the element width W. Specifically, as described above, it is hard to generate the erroneous operation such as chattering since the coercive force Hc is set to be comparatively large stable value. Therefore, it is possible to obtain stable operation characteristics.

According to the embodiment, it is preferable that the non-magnetic layer 18 be formed of Cu, and the thickness T of the non-magnetic layer 18 (see Fig. 4) be formed in the range of 17 Å to 19 Å. A magnitude of the interlayer coupling magnetic field Hin acting between the fixed layer 17 and the free layer 19 can change by changing the thickness T of the non-magnetic layer 18. The interlayer coupling magnetic field Hin is also used to control the magnetic sensitivity in the same as the coercive force Hc.

As described above, the interlayer coupling magnetic field Hin can be set at least 5 Oe (395 A/m) or more, preferably 10 Oe (790 A/m) or more, when the thickness of the non- magnetic layer 18 is in the range of 17 Å to 19 Å. Specifically, the interlayer coupling magnetic field Hin can be set to be larger than the coercive force Hc. Accordingly, the magnetic sensor 4 is effectively used in an opening and closing detection of the foldable cellular phone 1 shown in Figs. 1 and 2. The reason will be described by using a hysteresis characteristic illustrated in Fig. 14. Additionally, the hysteresis characteristic in Fig. 14 is based on a experiment result in Fig. 13, and the experiment will be described in detail later.

The horizontal axis in Fig. 14 is a magnitude of the external magnetic field H, the vertical axis is a magnitude of a resistance variation rate (ΔR/R) of the magneto-resistance element 8. A hysteresis loop HR indicates a portion surrounded by a curve HR1 and a curve HR2. The interlayer coupling magnetic field Hin is expressed by a magnitude of the magnetic field in the range from a line of the external magnetic field H equal to 0 (Oe) to a central point of the hysteresis loop HR. An extending width in a width direction of the hysteresis loop HR from an intermediate value between maximum and minimum of the resistance variation rate (ΔR/R) is expressed by 2 x coercive force Hc (denoted by 2Hc on the graph), and a central value of the extending width is a central point of the hysteresis. Assuming that one direction of the external magnetic field H is defined by a magnetic field of a positive value, the external magnetic field H of a negative value is expressed the magnetic field in a negative direction. As shown in the hysteresis characteristic illustrated in Fig. 14, the hysteresis loop HR is laid across the line of the external magnetic field H equal to 0 Oe and the hysteresis loop HR shifts to left side of the line of the external magnetic field H equal to 0 Oe in Fig. 14, since the interlayer coupling magnetic field Hin is larger than the coercive force Hc.

The opening and closing detection of the foldable cellular phone 1 shown in Figs. 1 and 2, a magnitude of the external magnetic field H applied by the magnet 5 is detected by the magnetic sensor 4. Accordingly, as illustrated in Fig. 14, the magnitude of the external magnetic field H can be effectively detected when the magneto-resistance element 8 has a characteristic shifting the hysteresis loop HR to any one of a positive or negative area of the external magnetic field H.

Now, a theory of an output of a switching signal will be described. For example, a 6 % of the resistance variation rate (ΔR/R) is set to be critical value. A central potential is derived when the 6 % of the resistance variation rate (ΔR/R) is obtained, and a voltage of the central potential is memorized in a control unit 30 as a critical voltage.

The resistance variation rate (ΔR/R) of the magneto-resistance element 8 gradually increases along with the hysteresis loop HR illustrated in Fig. 14 when the external magnetic field H permeates into the magnetic sensor 4 so as to increase the magnitude of the external magnetic field H (an absolute value). At that time, for example, when the control unit 30 performs to compare a voltage outputted from the magnetic sensor 4 with the critical voltage at intervals of a regular time and the control unit 30 judges that the voltage outputted from the magnetic sensor 4 is smaller than the critical voltage since the resistance variation rate (ΔR/R) of the magneto-resistance element 8 is over 6 %, thereby recognizing a folding state of the foldable cellular phone 1 and outputting a switching signal which sets switch off (In addition, generally in case of the switch OFF, there is no outputted signal). Conversely, when the magnitude of the external magnetic field H (an absolute value) permeating into the magnetic sensor 4 gradually decreases, for example the resistance variation rate (ΔR/R) of the magneto-resistance element 8 is below 6 %, and the control unit 30 judges that the voltage outputted from the magnetic sensor 4 is larger than the critical voltage, thereby recognizing an opening state of the foldable cellular phone 1 and outputting a switching signal which sets switch ON. Likewise, the control unit 30 is provided with a comparator comparing a variable output caused by the variation in a magnitude of the external magnetic field H with the predetermined critical voltage and has a function outputting the switching signal based on the comparison result.

As shown in Fig. 14, the resistance variation rate (ΔR/R) becomes 6 % when the external magnetic field H is about -60 Oe (about -4740 A/m) and -40 Oe (about -3160 A/m). To clarify, the coercive force Hc is about 10 Oe, and the curve HR1 and curve HR2 of the hysteresis loop HR are spaced from each other in the horizontal axis as shown in Fig. 14. Consequently, though there is some of the variation in a magnitude of the external magnetic field H, a fluctuation of the switching signal hardly occurs. Therefore, the erroneous operation such as the occurrence of the chattering can be properly prevented as mentioned above.

It is required to dispose a hysteresis circuit on purpose since there is no hysteresis in Hall element, but the magneto-resistance element doesn't require the hysteresis circuit. Therefore, the element can be formed in small size, and the power consumption is also decrease.

Next, a structure of a magnetic sensor 4 other than Fig. 4 will be described. For example, the magnetic sensor 42 is provided with two magneto-resistance elements 8 and 40 on the same base element 7 as shown in Fig. 5. An upper surface and lateral surface of the magneto-resistance element 40 is covered with a magnetic screening member 41, and formed to be a magnetic shield. Accordingly, the magneto-resistance element 40 performs the function of the fixed resistance element.

According to an embodiment in Fig. 5, the magneto-resistance elements 8 and 40 having perfectly the same structure (the magnetization direction of the fixed layer 17 is also the same.) is formed on the base element 7, that the magnetic sensor 42 can be easily manufactured. Moreover, most of characteristics such as temperature coefficients or resistances of the magneto-resistance elements 8 and 40 can be formed to coincide. Therefore, the magnetic sensor 42 having the stable magnetic sensitivity can be manufactured. Each layer forming the magneto-resistance elements 8 and 40 is commonly incorporated in the magneto-resistance element 8 as illustrated in Fig. 4, see the illustration in Fig.4.

According to an embodiment illustrated in Fig. 6, by using the interlayer coupling magnetic field Hin, a magnetic sensor 51 is formed so that an interlayer coupling magnetic field Hin of one side of a magneto-resistance element 50 is larger than the other side of the interlayer coupling magnetic field Hin of the magneto-resistance element 8. Layer structures of the magneto-resistance elements 8 and 50 are the same to each other, but a thickness of a non-magnetic layer 18 of the magneto-resistance element 50 is thinner than a thickness of a non-magnetic layer 18 of the magneto-resistance element 8. When the thickness T of the non-magnetic layer 18 changes as shown in Fig. 13, the interlayer coupling magnetic field Hin changes. According to the embodiment shown in Fig. 6 the thickness of the non-magnetic layer 18 in the magneto-resistance element 50 is formed to be thin, thereby increasing the interlayer coupling magnetic field Hin, and then the hysteresis loop HR largely shifts to one side as illustrated in Fig. 7. In addition, when the external magnetic field H is in the range of B as shown in Fig. 7, the magneto-resistance element 50 is not activated by a magneto-resistance effect and a resistance thereof does not change even under the altering external magnetic field H. Therefore, the magneto-resistance element 50 performs the function of the fixed resistance element. The magneto-resistance element 8 is activated by the magneto-resistance effect in the range B of the external magnetic field H, thereby functions as a variable resistance element which varies in resistance.

Next, a magnetic sensor 61 outputting switching signal , based on a polarity change of the external magnetic field H,will be described.

As illustrated in Fig. 9, the magnetic sensor 61 of the embodiment is disposed on wall surface 60 being a fixation portion.

In addition, a moving mechanism (not illustrated in the drawings) keeping a parallel state with the wall surface 60 and moving as a slide is provided near the wall surface 60 (a fixation portion). A pair of magnets M1 and M2 is fixed on a front end of the moving mechanism, and the pair of the magnets M1 and M2 are in the state of being possible to freely move in a direction illustrated Y1-Y2 on a front position (a X1 direction) of the magnetic sensor 61. The pair of the magnets M1 and M2 is set to have different polarities with each other.

A structure of the magnetic sensor 61 is, for example, similar to the illustration in Fig. 4. Specifically, the element width W of the magneto-resistance element 8 used in the magnetic sensor 61 is formed in the range of 1 µm to 5 µm (see Fig. 4). It is also preferable that the element length L be in the range of 50 µm to 250 µm. Accordingly, a coercive force Hc of a free layer 19 forming the magneto-resistance element 8 can be easily adjusted. As the embodiment, when the element width W is in the range of 1 µm to 5 µm, it is possible to secure a comparatively large coercive force Hc, and a variation of the coercive force Hc according to a variation of the element width W is not so big, that the coercive force Hc can be easily adjusted. In the embodiment, it is possible to set the coercive force Hc of the free layer 19 in the range of 5 Oe to 10 Oe (395 A/m to 790 A/m) by setting the element width W in the range of 1 µm to 5 µm.

The different portion between the magnetic sensor 61 illustrated in Fig. 9 and the magnetic sensor 4 illustrated in Fig. 4 is a thickness T of the non-magnetic layer 18. The thickness T of the non-magnetic layer 18 is controlled so that the interlayer coupling magnetic field Hin is larger than the coercive force Hc in the magnetic sensor 4 illustrated in Fig. 4, but the thickness T of the non-magnetic layer 18 is controlled so that the interlayer coupling magnetic field Hin is smaller than the coercive force Hc in the magnetic sensor 61 illustrated in Fig. 8. The non-magnetic layer 18 may be formed of Cu and the thickness T may be in the range of 19.5 Å to 21 Å in the magnetic sensor 61 illustrated in Fig. 9. As a result, the interlayer coupling magnetic field Hin can be formed to be smaller than 5 Oe (395 A/m), thereby being smaller than the coercive force Hc. It is also preferable that the interlayer coupling magnetic field Hin be as close to 0 Oe as possible.

Fig. 15 illustrates a hysteresis characteristic curve of the magneto-resistance element 8 used in the magnetic sensor 61. A horizontal axis in Fig. 15 represents a magnitude of the external magnetic field H, and a vertical axis represents the magnitude of a resistance variation rate (ΔR/R) of the magneto-resistance element 8. A hysteresis loop HR indicates a portion surrounded by a curve HR1 and a curve HR2. A thickness T of a non-magnetic layer 18 formed of Cu is 20 Å in the Fig. 15, and the interlayer coupling magnetic field Hin is set by 0 Oe or so as shown in the Fig. 13. According to the hysteresis characteristic curve illustrated in Fig. 15, since the interlayer coupling magnetic field Hin is smaller than the coercive force Hc, a central point of the hysteresis loop HR approximately exists on a line of an external magnetic field H equal to 0, curve HR1 and curve HR2 forming the hysteresis loop HR is extended in a width direction, and the hysteresis loop HR is laid across the line of the external magnetic field H equal to 0 Oe.

As shown in Fig. 10, when the moving mechanism moves in Y2 direction, then the a N pole of the magnet M1 is set to be a first position opposed to the sensor 61 (in Fig. 10, only the magneto-resistance element 8 of the magnetic sensor 61 is illustrated.). As shown in Fig. 11, when the moving mechanism moves in Y1 direction, then the a S pole of the magnet M2 is set to be a second position opposed to the sensor 61 (in Fig. 11, only the magneto-resistance element 8 of the magnetic sensor 61 is illustrated.).

As shown in Figs. 10 and 11, for example, a magnetization direction of the fixed layer 17 is el. As shown in Fig. 10, when the moving mechanism which is not illustrated moves to the first position in Y2 direction, that is, the N pole of the magnet M1 is opposed to the magnetic sensor 61, then a magnetization direction of the free layer 19 is toward a X2 direction which is the same direction with a magnetization direction el of the fixed layer since a direction of the external magnetic field H1 applied by magnet M1 is a X2 direction. At this time, the resistance variation rate (ΔR/R) of magneto-resistance element 8 becomes to the minimum.

Conversely, As shown in Fig. 11, when the moving mechanism moves to the second position in Y1 direction, that is, the S pole of the magnet M2 is opposed to the magnetic sensor 61, then a magnetization direction of the free layer 19 is set in a direction (a X1 direction) opposite to a magnetization direction e1 of the fixed layer since a direction of the external magnetic field H2 applied by magnet M2 is a X1 direction illustrated. At this time, the resistance variation rate (ΔR/R) of magneto-resistance element 8 becomes to the maximum.

The magnetic sensor 61 also has the control unit 30 illustrated in Fig. 8. The control unit 30 performs to compare a voltage outputted from the magnetic sensor 61 with a predetermined critical. Herein, for example, the voltage outputted from the magnetic sensor 61 is larger than the critical voltage, thereby outputting a switching signal which sets switch ON. Alternately, the voltage outputted from the magnetic sensor 61 is smaller than the critical voltage, thereby outputting a switching signal which sets switch OFF.

As shown in Figs. 10 and 11, the magnetic sensor 61 outputting the switching signal caused by detecting the polarity change of the external magnetic field can be formed so as to be the magnetic sensor 61 having a stable magnetic sensitivity and occurring a small irregularity in the characteristics, by using the magneto-resistance element 8 having the hysteresis characteristic illustrated in Fig. 15.

Namely, when the hysteresis loop HR spreads in a horizontal axis and is laid across the line of the external magnetic field H equal to 0, and for example, if the resistance variation rate (ΔR/R) of -4 % is set to be critical value as shown in Fig. 15, then the external magnetic field H at the time when the resistance variation rate (ΔR/R) is -4 % respectively exists on a positive area (about 10 to 15 Oe) and a negative area (about -15 Oe). There exist positive and negative values in the external magnetic field H since the polarities of the external magnetic field H acting the magneto-resistance element 8 are different. Therefore, the state in Fig. 10 (the state that the magneto-resistance element 8 faces to the N pole of the magnet) is in state that the external magnetic field H is a positive value, and the state in Fig. 11 (the state that the magneto-resistance element 8 faces to the S pole of the magnet) is in state that the external magnetic field H is a negative value. Consequently, in each case that the polarities of the external magnetic field H acting on the magneto-resistance element 8 are different from each other, it is possible to obtain the resistance variation rate (ΔR/R) of -4 %. Therefore, it is possible to output the switching signal based on the polarity change of the external magnetic field.

According to aforementioned embodiment, the magnetic sensors 4 and 61 do not include the magnets 5, M1, and M2, but it may define so that the magnetic sensors 4 and 61 include the magnets 5, M1, and M2.

The magnetic sensors 4 and 61 of the aforementioned embodiment is provided with one of the magneto-resistance element 8 and one of the fixed resistance element on the base element 7, but it may be possible to set a configuration provided with two of a bridge circuit including one of the magneto-resistance element 8 and one of the fixed resistance element (i.e. two magneto-resistance elements 8 and two fixed resistance elements), and a configuration provided with just one of the magneto-resistance element 8.

Furthermore, the magnetic sensor 4 according to the embodiment is available for an opening and closing detection of the foldable cellular phone 1, but it may be available for an opening and closing detection of a game device. The magnetic sensors 4 and 61 according to the embodiment may be also available for a sensor detecting a rotating angle like a throttle position sensor, an encoder, a terrestrial magnetic sensor (a bearing sensor) and the like. On this occasion, according to the embodiment, it is possible to perform easily a magnetic sensing control, by controlling the coercive force Hc and the interlayer coupling magnetic field Hin so as to match for use of the magnetic sensor.

It is an option whether or not a bias magnetic field is applied on the magneto-resistance element. It may be allowed that the bias magnetic field is not applied on the free magnetic layer forming the magneto-resistance element.

### EXAMPLES

By using the magneto-resistance element 8 of a line shape illustrated in Fig. 3, a relation between the element width W and the coercive force Hc of the free layer 19 was researched.

A film configuration of the magneto-resistance element 8 using in the experiment was sequentially laminated from the bottom of a seed layer: NiFeCr / an anti-ferromagnetic layer: IrMn / a fixed layer: [Fe_{30at%}Co_{70at%} / Ru / CoFe] / a non-magnetic layer: Cu / a free layer: [CoFe / NiFe] / a passivation layer: Ta. After forming films of the magneto-resistance element 8, a heat process under a magnetic field was performed to thereof so as to fix the magnetization direction of the fixed layer in one direction. The free layer was formed of CoFe having a thickness of 10 Å and NiFe having a thickness of 30 Å.

According to the experiment, a relation between the element width W at the time when the element length L of the magneto-resistance element 8 was changed in the range of 50 µm to 250 µm and the coercive force Hc of the free layer 19 was researched. The result is illustrated in the Fig. 12.

As shown in Fig. 12, it could be realized that the coercive force Hc does almost not depend on the element length L, but depends on the element width W. As shown in Fig. 12, it could be realized that the element width W gradually decreases and the coercive force Hc gradually increases. It could be also realized that the coercive force Hc highly increases when the element width W is set to be smaller than 1 µm as shown in Fig. 12.

From the experiment result in Fig. 12, the element width W was set to be in the range of 1 µm to 5 µm. If the element width W set to be larger than 5 µm, the coercive force Hc too decreases, that a magnetic sensitivity decreases in stability by occurring such as a chattering, and a resistance also decreases. Therefore, to obtain a large predetermined resistance, it is required to set a long element length L. In this case, it is not preferable since the magnetic sensor increases in size. Conversely, if the element width W is set to be smaller than 1 µm, a variation in the coercive force Hc is too large, that a setting of the predetermined coercive force Hc becomes difficult, and an irregularity easily occurs in the magnetic sensitivity. As a result, according to the present example, the element width W was set in the range of 1 µm to 5 µm.

In the next, by using the magneto-resistance element 8 including the film configuration mentioned above, a relation between a thickness T of the non-magnetic layer 18 formed of Cu and the interlayer coupling magnetic field Hin between the fixed layer 17 and free layer 19 was researched. The result is illustrated in Fig. 13.

As shown in Fig. 13, it was recognized that the interlayer coupling magnetic field Hin is changed by the thickness T of the Cu layer. As shown in Fig. 13, it was also realized that the interlayer coupling magnetic field Hin can be set to be larger than 5 Oe when the thickness T of the Cu layer is set to be in the range of 17 Å to 19 Å. In addition, a minimum value of the thickness T of the Cu layer is set by 17 Å, since a control of the thickness T is difficult when the thickness T is set to be smaller than 17 Å. It is also realized that if the thickness T of the Cu layer is set to be in the range of 19.5 Å to 21 Å, the interlayer coupling magnetic field Hin can be smaller than 5 Oe.

Fig. 14 shows a hysteresis characteristic curve when the thickness of the Cu layer was set to be 17.5 Å. Additionally, the coercive force Hc was 10 Oe. As mentioned above, the magneto-resistance element having the hysteresis characteristic illustrated in Fig. 14 can be effectively used for a magnetic sensor outputting ON and OFF switching signals based on a variation in a magnitude of the external magnetic field H.

Next, Fig. 15 shows a hysteresis characteristic curve when the thickness of the Cu layer was set to be 20 Å. Additionally, the coercive force Hc was 10 Oe. As mentioned above, the magneto-resistance element having the hysteresis characteristic illustrated in Fig. 15 can be effectively used for a magnetic sensor outputting ON and OFF switching signals based on a polarity change in the external magnetic field H.

## Claims

1. A magnetic sensor comprising a magneto-resistance element, the magneto-resistance element comprising;
an anti-ferromagnetic layer,
a fixed magnetic layer being in contact with the anti-ferromagnetic layer, and
a free magnetic layer opposing to the fixed magnetic layer via a non-magnetic layer interposed therebetween, the free magnetic layer has a magnetization direction that varies in accordance with an external magnetic field, and
wherein the magneto-resistance element is in a slender and longitudinal shape and has an element length L greater than an element width W that is in the range of 1 µm to 5 µm.

2. The magnetic sensor according to claim 1, wherein the element length L is in the range of 50 µm to 250 µm.

3. The magnetic sensor according to claim 1 or 2, wherein, the non-magnetic layer is formed of Cu and a thickness of the non-magnetic layer is in the range of 17 Å to 19 Å.

4. The magnetic sensor according to claim 3, further comprising a control unit outputting a switching signal on the basis of a variation in output due to a variation in magnitude of the external magnetic field.

5. The magnetic sensor according to any of claims 1 to 4, wherein the non-magnetic layer is formed of Cu and a thickness of the non-magnetic layer is in the range of 19.5 Å to 21 Å.

6. The magnetic sensor according to claim 5, further comprising a control unit outputting a switching signal on the basis of a variation in output due to a polarity change of the external magnetic field.

7. A magnetic sensor comprising a magneto-resistance element, the magneto-resistance element comprising;
an anti-ferromagnetic layer,
a fixed magnetic being in contact with the anti-ferromagnetic layer, and
a free magnetic layer opposing to the fixed magnetic layer via a non-magnetic layer interposed therebetween, free magnetic layer has a magnetization direction varies with an external magnetic field, and
wherein an interlayer coupling magnetic field Hin acting between the fixed magnetic layer and the free magnetic layer has a greater strength than that of a coercive force Hc of the free layer.
